# EUROPEAN PATENT APPLICATION

(11) **EP 1 069 628 A2**
(43) Date of publication of application: **17.01.2001**
(21) Application number: 00115313.9
(22) Date of filing: 14.07.2000
(51) Int. Cl.: H01L 51/20

(54) **Organic electroluminescent device and method for fabricating same**

(30) Priority: 14.07.1999 JP 20027999; 19.07.1999 JP 20431799
(71) Applicant: NEC CORPORATION, Tokyo (JP)
(72) Inventor: Morioka, Yukiko, Minato-ku, Tokyo (JP); Oda, Atsushi, Minato-ku, Tokyo (JP); Ishikawa, Hitoshi, Minato-ku, Tokyo (JP); Toguchi, Satoru, Minato-ku, Tokyo (JP); Tada, Hiroshi, Minato-ku, Tokyo (JP)
(74) Representative: Glawe, Delfs, Moll & Partner

(57) **Abstract**

An organic EL device including at least an anode (12), a cathode and an organic (15) light-emitting zone with high brightness, high efficiency, low operating voltage and long lifetime is provided. The anode (12)irradiated with ultraviolet light of wavelength 100-200 nm is used in the device.

## Description

### BACKGROUND OF THE INVENTION

### (a) Field of the Invention

The present invention relates to an organic electroluminescent device (hereinafter referred to as "organic EL device"), more in detail to the organic EL device having a higher brightness, a longer lifetime and a higher efficiency with a lower driving voltage, and a method for fabricating the same.

### (b) Description of the Related Art

An organic EL device is a light-emitting device which makes use of the principle that when an electric field is applied, a fluorescent material emits light in response to the charge recombination of holes injected from an anode and electrons injected from a cathode. After C.W. Tang et al. of Eastman Kodak Company reported a low-voltage-driven organic EL device using a double layered structure (C.W. Tang, S.A. Vanslyke, Applied Physics Letters, 51, 913(1987) and the like), studies on an organic EL device have been briskly carried out. Tang et al. reported an organic EL device using tris(8-hydroxyquinolinol aluminum) in an electron-transporting and light-emitting layer and a triphenyldiamine derivative in a hole-transporting layer. This stacked structure gives such advantages as an improvement in the injection efficiency of holes into the light-emitting layer; blocking of electrons injected from a cathode, which increase the efficiency of exciton production from charge recombination; and confinement of the excitons into the light-emitting layer. A double layered structure composed of a hole-injecting and transporting layer and an electron-transporting and light-emitting layer or a triple layered structure composed of a hole-injecting and transporting layer, an electron-transporting and light-emitting layer and an electron-injecting and transporting layer is well known as an organic EL device. In order to increase the recombination efficiency of injected holes and electrons, various improvements in the device structure or fabrication process have been introduced to such multi-layered devices. As a hole-transporting material, triphenylamine derivatives such as 4,4' ,4'' -tris(3-methylphenylphenylamino)-triphenylamine and aromatic diamine derivatives such as N,N' -diphenyl-N,N' - bis(3-methylphenyl)-[1,1' -biphenyl]-4,4' -diamine, which are starburst molecules, are well known (e.g., Japanese Patent Application Laid-Open Nos. 20771/1996, 40995/1996, 40997/1996 and 87122/1996).

As an electron-transporting material, oxadiazole derivatives, triazole derivatives and the like are well known.

As an electron-transporting and light-emitting material, chelate complexes such as tris(8-quinolinolate)aluminum complex are known, and it is also well-known that devices using the mixture of a light-emitting material and a small amount of a fluorescent pigment have an improved efficiency. As these fluorescent pigments, there are known coumarin derivatives, tetraphenylbutadiene derivatives, bisstyrylarylene derivatives, oxadiazole derivatives, porphyrin derivatives, phenoxazoline type pigments, rhodamine type pigments, acridine type pigments and the like. It is reported that various color light in a visible region from blue to red are obtained from these materials, and realization of a full color organic EL device is expected (e.g., Japanese Patent Application Laid-Open Nos. 239655/1996, 138561/1995, 200289/1991 and the like).

However, although the emission efficiency of a triple or more layered organic EL device is high, the driving voltage is increased due to the increase of carrier injection barriers and film thickness as a whole. Further, when the conventional electron-transporting and light-emitting layer is used, there is the disadvantage that the operating voltage is increased due to a high barrier to injection of holes into the light-emitting layer. On the other hand,the devices composed of a hole-injectable light-emitting layer contacting with anode have lower threshold voltage for light-emission. However, there is the disadvantage that the emission efficiency is decreased when high voltage is applied to the devices.

The process for the fabrication of the devices with high performance is also reported. For example, the devices using ITO films which are exposed to plasma have lower threshold voltage for light-emission than devices using ITO not exposed (e.g. Extended Abstracts of The 44^{th} Spring Meeting (Japanese), Jpn. Soc. Appl. Phys., 1997, No.3, pp.1148, 29a-NK-3). It is also reported that devices using ITO films which are exposed to UV light don't have improved emission efficiency (Japanese Patent Application Laid-Open No. 261484/1998).

In recent days, organic EL devices with high brightness and long lifetime have been disclosed or reported, but any of them are not enough in these properties. There is thus a strong need for development of materials and fabrication methods for EL devices with having excellent performance.

### SUMMARY OF THE INVENTION

The object of the present invention is to provide an organic EL device with high brightness, high emission efficiency, long lifetime and low operating voltage.

The present invention provides, in a first aspect thereof, an organic EL device including: an anode irradiated with ultraviolet light of wavelength 100-200 nm, a light-emitting zone adjacent to the anode, and a cathode.

The present invention provides, in a second aspect thereof, a method for fabricating an organic EL device including the steps of: irradiating an anode with ultraviolet light of wavelength 100-200 nm; forming an organic layer including a light-emitting zone adjacent to the anode; and forming a cathode on the organic layer.

The present invention provides, in a third aspect thereof, an organic EL device including: an anode irradiated with ultraviolet light of wavelength 100-200 nm, a hole-injecting zone which contains, either singly or as a mixture, a compound represented by following general Formula 62, a light-emitting zone and a cathode (wherein, Ar₁₁ and Ar_{12,} each independently represents a substituted or non-substituted arylene group having 5 to 42 carbon atoms, and Ar₁₃ to Ar_{17,} each independently represents a substituted or non-substituted aryl group having 6 to 20 carbon atoms, whereupon substituted groups thereof are a halogen atom, a hydroxyl group, a nitro group, a cyano group, a substituted or non-substituted alkyl group, a substituted or non-substituted alkenyl group, a substituted or non-substituted cycloalkyl group, a substituted or non-substituted alkoxy group, a substituted or non-substituted aromatic hydrocarbon group, a substituted or non-substituted aromatic heterocyclic group, a substituted or non-substituted aralkyl group, a substituted or non-substituted aryloxy group, a substituted or non-substituted alkoxycarbonyl group and a carboxyl group).

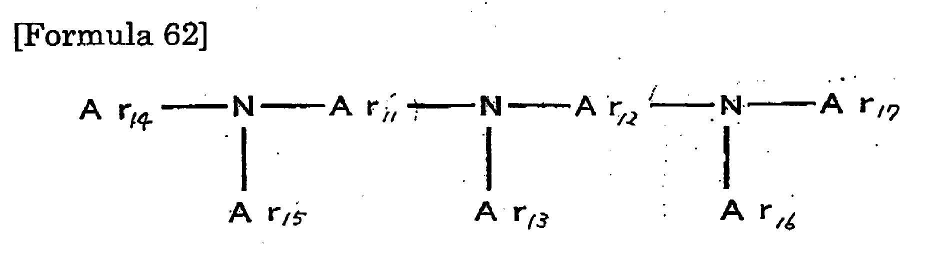

The present invention provides, in a fourth aspect thereof, a method for fabricating an organic EL device including the steps of: irradiating an anode with ultraviolet light of wavelength 100-200 nm; forming a hole-injecting zone on the anode; forming a light-emitting zone; forming an electron-injecting zone; and forming a cathode on the organic layers.

The devices composed of an anode exposed to ultraviolet light of wavelength 100-200 nm have a higher brightness, a longer lifetime, higher emission efficiency and lower operating voltage, so the effects of the present invention are outstanding.

The above and other objects, features and advantages of the present invention will be more apparent from the following description.

### BRIEF DESCRIPTION OF DRAWINGS

Fig.1 is a cross-sectional view showing an organic EL device in accordance with a first embodiment of the present invention.
Fig.2 is a cross-sectional view showing an organic EL device in accordance with a second embodiment of the present invention.
Fig.3 is a cross-sectional view showing an organic EL device in accordance with a third embodiment of the present invention.
Fig.4 is a cross-sectional view showing an organic EL device in accordance with a fourth embodiment of the present invention.
Fig.5 is a cross-sectional view showing an organic EL device in accordance with a fourth embodiment of the present invention.
Fig.6 is a graph showing the luminance-applied voltage characteristics of the organic EL devices of Example 3 and Comparative Examples 3 to 5.
Fig.7 shows the current efficiencies-current densities characteristics of the organic EL devices of Example 3 and Comparative Examples 3 to 5.
Fig.8 shows the luminance-applied voltage characteristics of the organic EL devices of Example 5 and Comparative Examples 7.
Fig.9 shows the current efficiencies-current densities characteristics of the organic EL devices of Example 5 and Comparative Examples 7.
Fig.10 shows the luminance-applied applied voltage characteristics of the organic EL devices of Example 11 and Comparative Examples 17,18,22 and 23.
Fig.11 shows the current efficiencies-current densities characteristics of the organic EL devices of Example 11 and Comparative Examples 17,18,22 and 23.

### PREFERRED EMBODIMENTS OF THE INVENTION

Now, the present invention is more specifically described with reference to accompanying drawings.

The structure of the organic EL device in accordance with the first and the second aspects of the present invention (hereinafter referred to as "first invention") includes one or more organic layers between the electrodes.

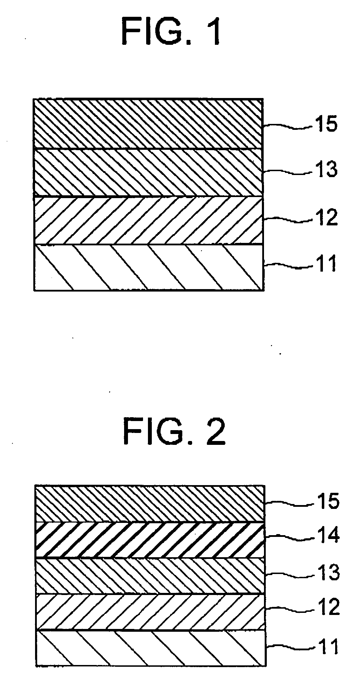

A first embodiment of the organic EL device in accordance with the first invention shown in Fig.1 includes an anode 12, a light-emitting zone 13 and a cathode 15 overlying a substrate 11.

A second embodiment of the organic EL device in accordance with the first invention shown in Fig.2 includes the anode 12, the light-emitting zone 13, an electron-injecting zone 14 and the cathode 15 overlying the substrate 11.

The structure of the organic EL device in accordance with the third and fourth aspects of the present invention (hereinafter referred to as "second invention") preferably includes two or more organic layers between the electrodes.

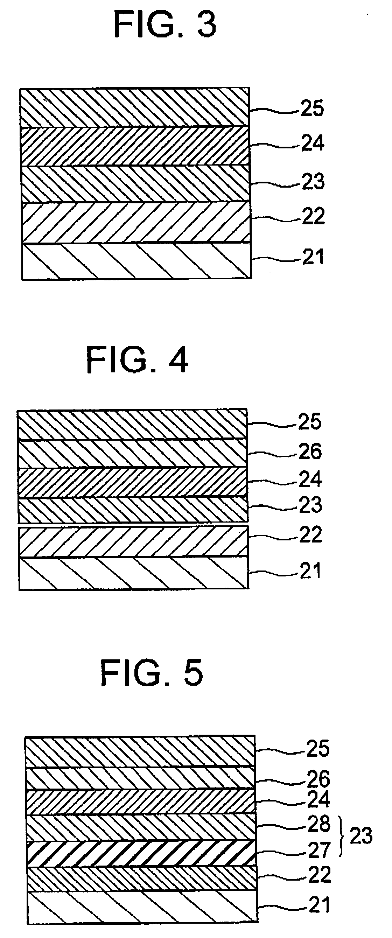

A third embodiment of the organic EL device in accordance with the second invention shown in Fig.3 includes an anode 22, a hole-injecting zone 23, a light-emitting zone 24 and a cathode 25 overlying a substrate 21.

A fourth embodiment of the organic EL device in accordance with the second invention shown in Fig.4 includes the anode 22, the hole-injecting zone 23, the light-emitting zone 24, an electron-injecting zone 26 and the cathode 25 overlying the substrate 21.

The anodes 12, 22 of all the embodiments are irradiated with ultraviolet light of wavelength 100-200 nm.

There is no particular limitation on selection the lamp for irradiating so long as emitting light of wavelength 100-200 nm and having power of 1 mW/cm2 or more. The examples of the lamp include an excimer UV lamp, an excimer laser and a deuterium lamp.

It is well known that the ultraviolet light of wavelength 100-200 nm according to the present invention is absorbed by atmospheric oxygen and makes oxygen radicals (R. Kingslake, Applied Optics and Optical Engineering I, Academic Press, New York and London, p.131, 1965). The oxygen composition of anode materials in surface region of anode is increased because of the oxygen radical generation and a photoelectric effect to the anode material. This varies properties of interface between organic thin layer and anode and improves EL properties, i.e. brightness, operation voltage, efficiency and lifetime, of the devices. Because of the cleaning of the anode by the resulting oxygen radical, the coherence between the anode and the organic thin layer is enhanced and the performances of the organic EL device are improved.

The irradiation of the anode by the ultraviolet light of wavelength 100-200 nm provides a further effect when the anode is preprocessed with a wet cleaning method, ozone cleaning or an exposure of plasma such as oxygen.

The anode of the organic thin film EL device plays the role of injecting holes into the light-emitting zone or the hole-injecting zone, and the anode having a work function of 4 eV or more, preferably 4.5 eV or more is effective. The anode material employable in the present invention is preferably an electroconductive oxide. Specific examples of the anode used in the present invention include indium-tin oxide alloy (ITO), tin oxide (NESA), tin-antimony oxide alloy (ATO), zinc oxide and zinc-aluminum alloy (AZO).

The cathode plays the role of injecting electrons into the light-emitting zone or the electron-injecting zone and is preferably made of a material having a smaller work function. Although there is no particular limitation imposed on the cathode material, specific examples include indium, aluminum, magnesium, magnesium-indium alloy, magnesium-aluminum alloy, aluminum-lithium alloy, aluminum-scandium-lithium alloy and magnesium-silver alloy.

The layer in contact with the anode among one or more organic thin films forming the light-emitting zone employable in the first invention is made of a compound represented by Formula 1.

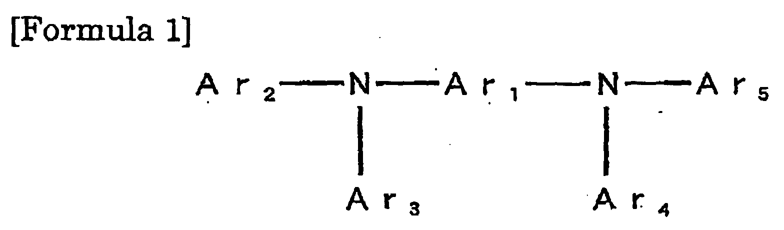

In the Formula 1, Ar₁ designates a substituted or non-substituted arylene group having 5 to 42 carbon atoms. Examples of such a group include naphtylene group, anthranylene group, perylenylene group, 1:2 benzoperylenylene group, 1:2:7:8 dibenzoperylenylene group, 1:2:11:12 dibenzoperylenylene group, terylenylene group, pentacenylene group, bisanthrenylene group, 10,10'-(9,9'-bisanthryl)-ylene group, 4,4'-(1,1'-binaphtyl)-ylene group, 4,10'-(1,9'-naphtylanthryl)-ylene group, a bivalent group designated by the following Formula 2 (wherein, Ar₆ to Ar₈ each are naphtylene group or anthranylene group).

―Ar₆―Ar₇―Ar₈ [FORMULA 2]

The examples further include a bivalent group formed by two hydrogen atoms removal from aromatic hydrocarbons or condensed polycyclic hydrocarbons such as phenanthrene, pyrene and terphenyl;, or heterocyclic compounds or a condensed heterocyclic compounds such as carbazole, pyrrole, thiophene, furan, imidazole, pyrazole, isothiazole, isoxazole, pyridine, pyrathne, pyrimidine, pyridazine, furazane, thianthrene, isobenzofuran, phenoxazine, indolizine, indole, isoindole, 1H-indazole, purine, quinoline, isoquinoline, phthalazine, naphthyridine, quinoxaline, quinazoline, cinnoline, pteridine, β-carbazoline, phenanthridine, acridine, perimidine, phenanthroline, phenazine and phenothiazine. Ar₂ to Ar_{5,} each independently represents a substituted or non-substituted aryl group having 6 to 20 carbon atoms, and at least one of Ar₂ to Ar₅ has a substituted or non-substituted styryl group as a substituent.

Examples of such aryl group having 6 to 20 carbon atoms include phenyl group, naphthyl group, anthryl group, phenanthryl group, naphthacenyl group and pyrenyl group.

Examples of a halogen atom as a substituent include fluorine, chlorine, bromine and iodine.

The substituted or non-substituted amino group is designated by -NX₁X₂. Examples of X₁ and X₂ include, independently with each other, hydrogen atom, methyl group, ethyl group, propyl group, isopropyl group, n-butyl group, s-butyl group, isobutyl group, t-butyl group, n-pentyl group, n-hexyl group, n-peptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisobutyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroetbyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinirtroisopropyl group, 2,3-dinitro-t-butyl group, 1,2,3-trinitropropyl group, phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9- naphthacenyl group, 4-styrylphenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4' - methylbiphenylyl group, 4'' -t-butyl-p-terphenyl-4-yl group, 2-pyrrolyl group, 3-pyrrolyl group, pyrazinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 1-phenanthrithnyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthroline-2-yl group, 1,7-phenanthroline-3-yl group, 1,7-phenanthroline-4-yl group, 1,7-phenanthroline-5-yl group, 1,7-phenanthroline-6-yl group, 1,7-phenanthroline-8-yl group, 1,7-phenanthroline-9-yl group, 1,7-phenanthroline-10-yl group, 1,8-phenanthroline-2-yl group, 1,8-phenanthroline-3-yl group, 1,8-phenanthroline-4-yl group, 1,8-phenanthroline-5-yl group, 1,8-phenanthroline-6-yl group, 1,8-phenanthroline-7-yl group, 1,8-phenanthroline-9-yl group, 1,8-phenanthroline-10-yl group, 1,9-phenanthroline-2-yl group, 1,9-phenanthroline-3-yl group, 1,9-phenanthroline-4-yl group, 1,9-phenanthroline-5-yl group, 1,9-phenanthroline-6-yl group, 1,9-phenanthroline-7-yl group, 1,9-phenanthroline-8-yl group, 1,9-phenanthroline-10-yl group, 1,10-phenanthroline-2-yl group, 1,10-phenanthroline-3-yl group, 1,10-phenanthroline-4-yl group, 1,10-phenanthroline-5-yl group, 2,9-phenanthroline-1-yl group, 2,9-phenanthroline-3-yl group, 2,9-phenanthroline-4-yl group, 2,9-phenanthroline-5-yl group, 2,9-phenanthroline-6-yl group, 2,9-phenanthroline-7-yl group, 2,9-phenanthroline-8-yl group, 2,9-phenanthroline-10-yl group, 2,8-phenanthroline-1-yl group, 2,8-phenanthroline-3-yl group, 2,8-phenanthroline-4-yl group, 2,8-phenanthroline-5-yl group, 2,8-phenanthroline-6-yl group, 2,8-phenanthroline-7-yl group, 2,8-phenanthroline-9-yl group, 2,8-phenanthroline-10-yl group, 2,7-phenanthroline-1-yl group, 2,7-phenanthroline-3-yl group, 2,7-phenanthroline-4-yl group, 2,7-phenanthroline-5-yl group, 2,7-phenanthroline-6-yl group, 2,7-phenanthroline-8-yl group, 2,7-phenanthroline-9-yl group, 2,7-phenanthroline-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3- phenoxazinyl group, 4- phenoxazinyl group, 2-oxazolyl group, 4-oxazolyl group, 5-oxazolyl group, 2-oxadiazolyl group, 5-oxadiazolyl group, 3-hurazanyl group, 2 thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl1-indolyl group, 4-t-butyl-1-indolyl group, 2-t-butyl-3-indolyl group, and 4-t-butyl-3-indolyl group.

Examples of the substituted or non-substituted alkyl group include methyl group, ethyl group, propyl group, isopropyl group, n-butyl, s-butyl, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-chloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoehtyl group, 1,3-dicyanoisopropy group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, and 1,2,3-trinitropropyl group.

Examples of the substituted or non-substituted alkenyl group include vinyl group, allyl group, 1-butenyl group, 2-butenyl group, 3-butenyl group, 1,3-butanedienyl group, 1-methylvinyl group, styryl group, 2,2-diphenylvinyl group, 1,2-diphenylvinyl group, 1-methylallyl group, 1,1-dimethylallyl group, 2-methylallyl group, 1-phenylallyl group, 2-phenylallyl group, 3-phenylallyl group, 3,3-diphenylallyl group, 1,2-dimethylallyl group, 1-phenyl-1-butenyl group and 3-phenyl-1-butenyl group.

Examples of the substituted or non-substituted cycloalkyl group include cyclopropyl group, cyclobutyl group, cyclopentyl group, cyclohexyl group, and 4-methylcyclohexyl group.

The substituted or non-substituted alkoxy group is represented by -OY and examples of Y include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2, 3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

Examples of the substituted or non-substituted aromatic hydrocarbon group include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4' -methylbiphenylyl group and 4'' - t-butyl-p-terphenyl-4-yl group.

Examples of the substituted or non-substituted aromatic heterocyclic group include 1-pyrrolyl group, 2-pyrrolyl group, 3-pyrrolyl group, pyrazinyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl, group, 9-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-mehyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group.

Examples of the substituted or non-substituted aralkyl group include benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylmethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group and 1-chloro-2-phenylisopropyl group.

The substituted or non-substituted aryloxy group is represented by -OZ, wherein Z may be phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4''-t-butyl-p-terphenyl-4-yl group, 2-pyrrolyl group, 3-pyrrolyl group, pyrazinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1, 8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-mehyl-3-indolyl group, 4-methyl-3-indolyl group, 2-t-butyl1-indolyl group, 4-t-butyl1-indolyl group, 2-t-butyl-3-indolyl group and 4-t-butyl-3-indolyl group.

The substituted or non-substituted alkoxycarbonyl group is represented by -COOY, wherein Y may be methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2, 3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group and 1,2,3-trinitropropyl group.

Examples of the styryl group which at least one of Ar₂ to Ar₅ has as a substituent include non-substituted styryl group and 2,2'-diphenylvinyl group. In addition, the substituted styryl group can be employed having, as a substituent of a terminal phenyl group, a halogen atom, hydroxyl group, the above substituted or non-substituted amino group, nitro group or cyano group, the above substituted or non-substituted alkyl group, the above substituted or non-substituted alkenyl group, the above substituted or non-substituted cycloalkyl group, the above substituted or non-substituted alkoxyl group, the above substituted or non-substituted aromatic hydrocarbon group, the above substituted or non-substituted aromatic heterocyclic group, the above substituted or non-substituted aralkyl group, the above substituted or non-substituted aryloxy group, the above substituted or non-substituted alkoxycarbonyl group, and carboxyl group as well as substituted 2,2'-diphenylvinyl group can be employed.

Examples of divalent groups forming a ring include tetramethylene group, pentamethylene group, hexamethylene group, diphenylmethan-2,2'-diyl group, diphenylethan-3,3'-diyl group and diphenylpropan-4,4'-diyl group.

Following are examples of compounds used in the layer in contact with the anode, among one or more of the organic thin layers forming the light-emitting zone of the first invention. But the first invention is not limited to these examples unless the spirit or scope of the invention is changed.

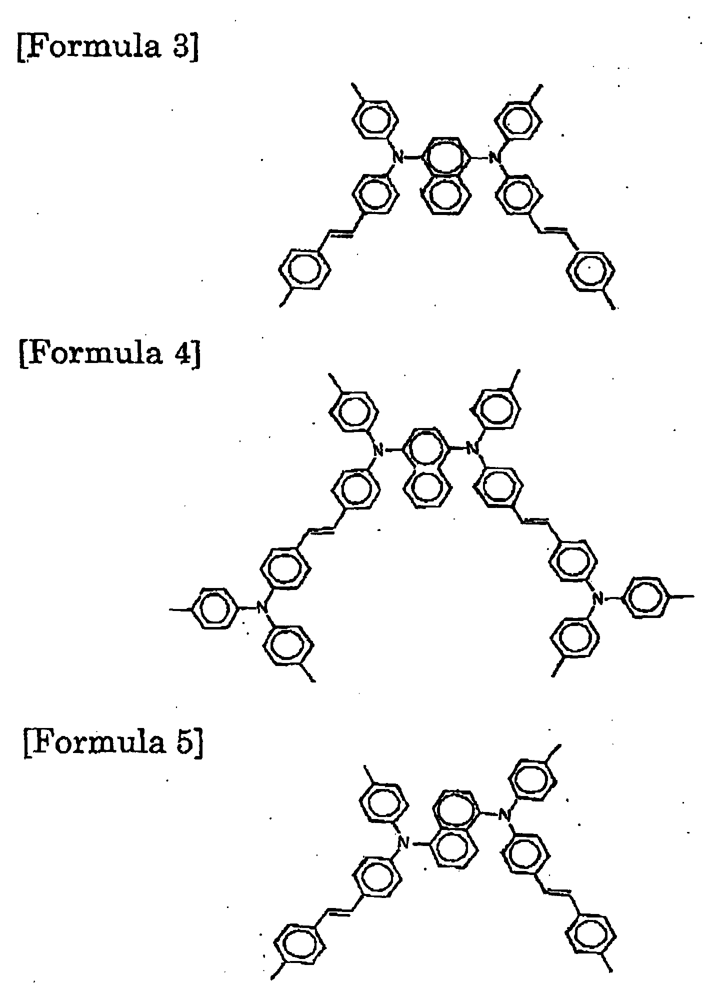

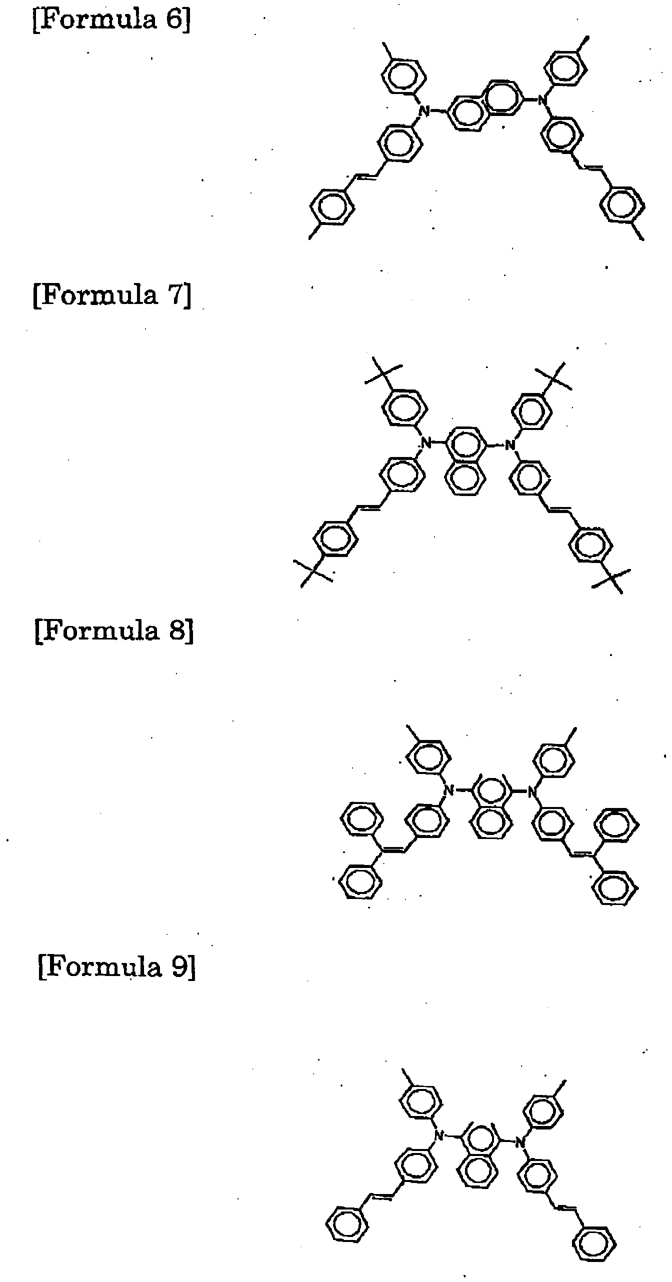

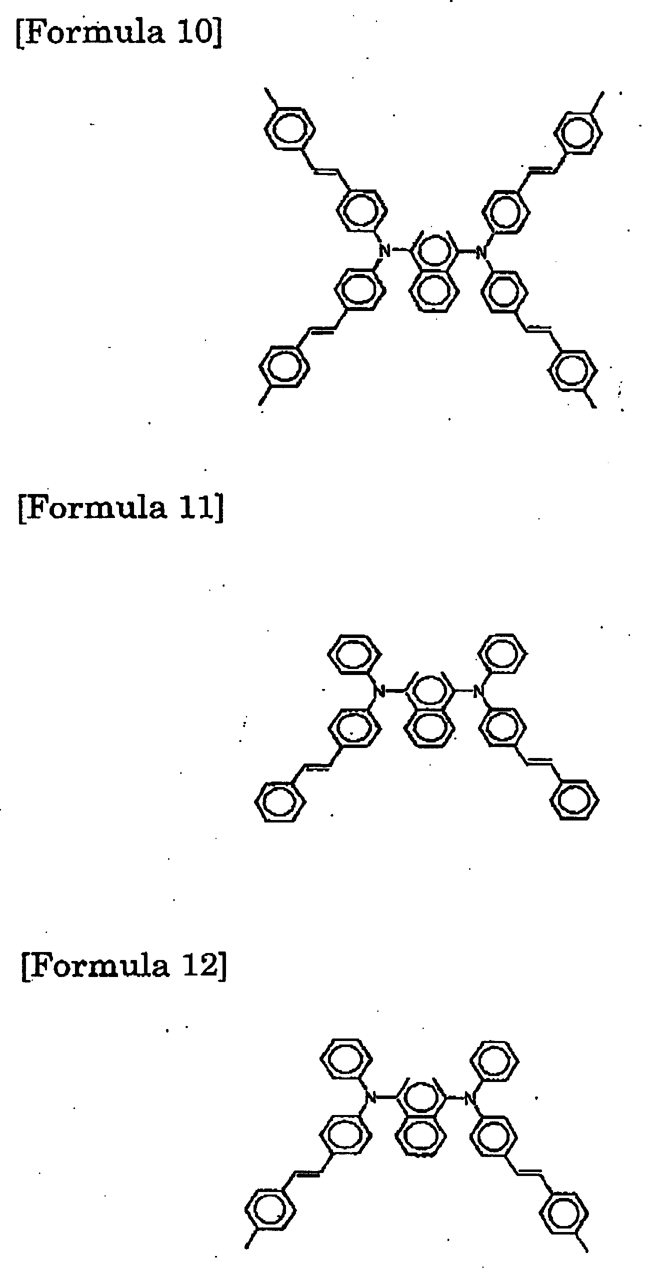

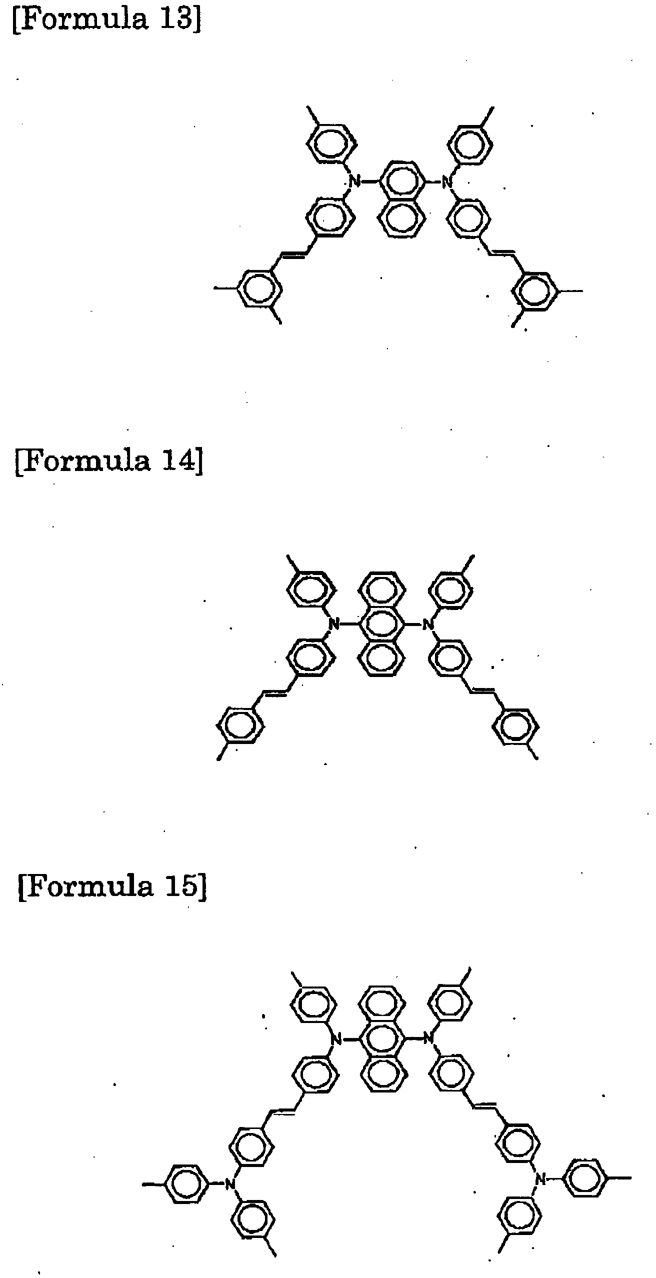

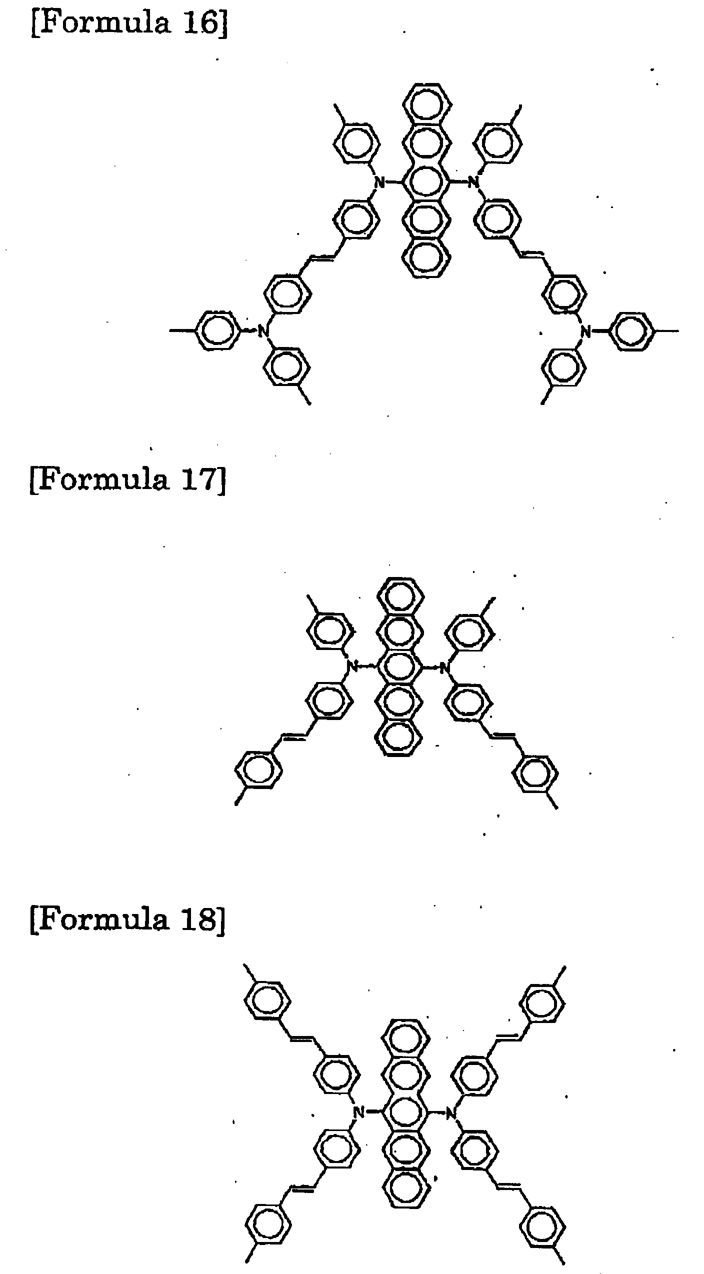

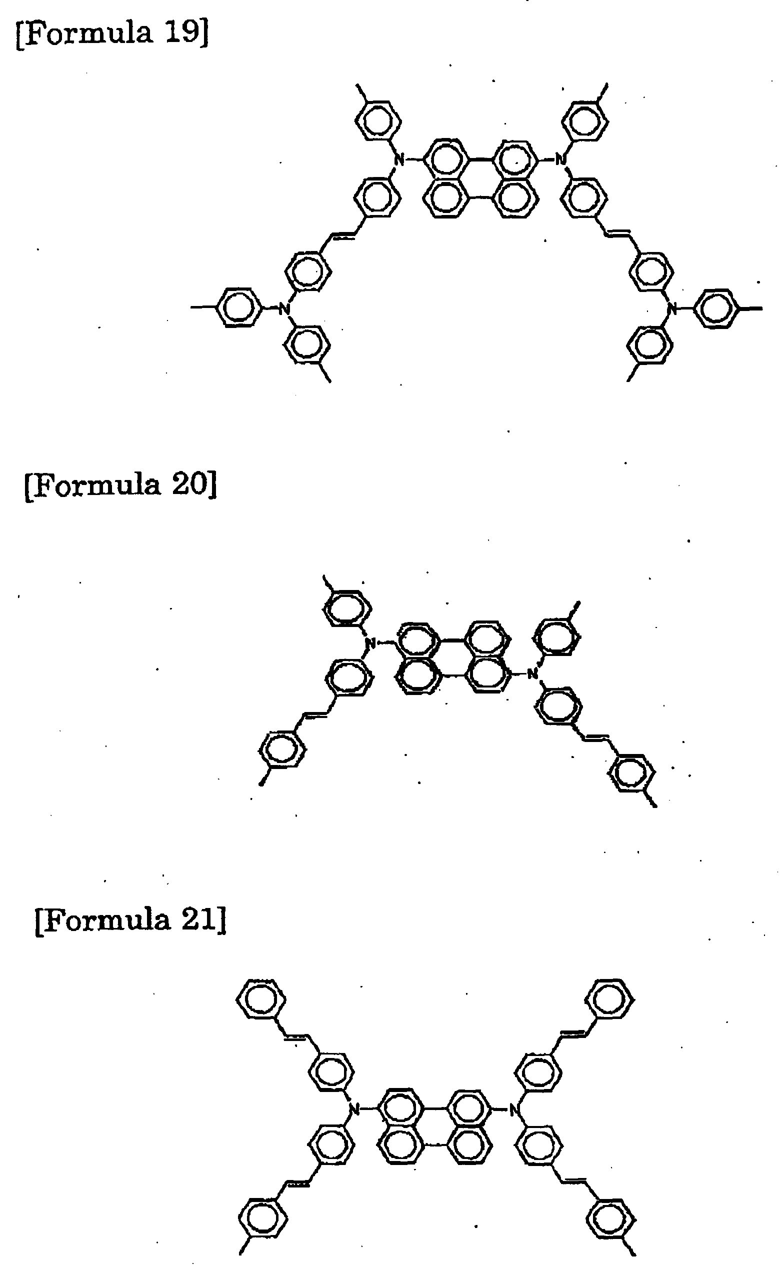

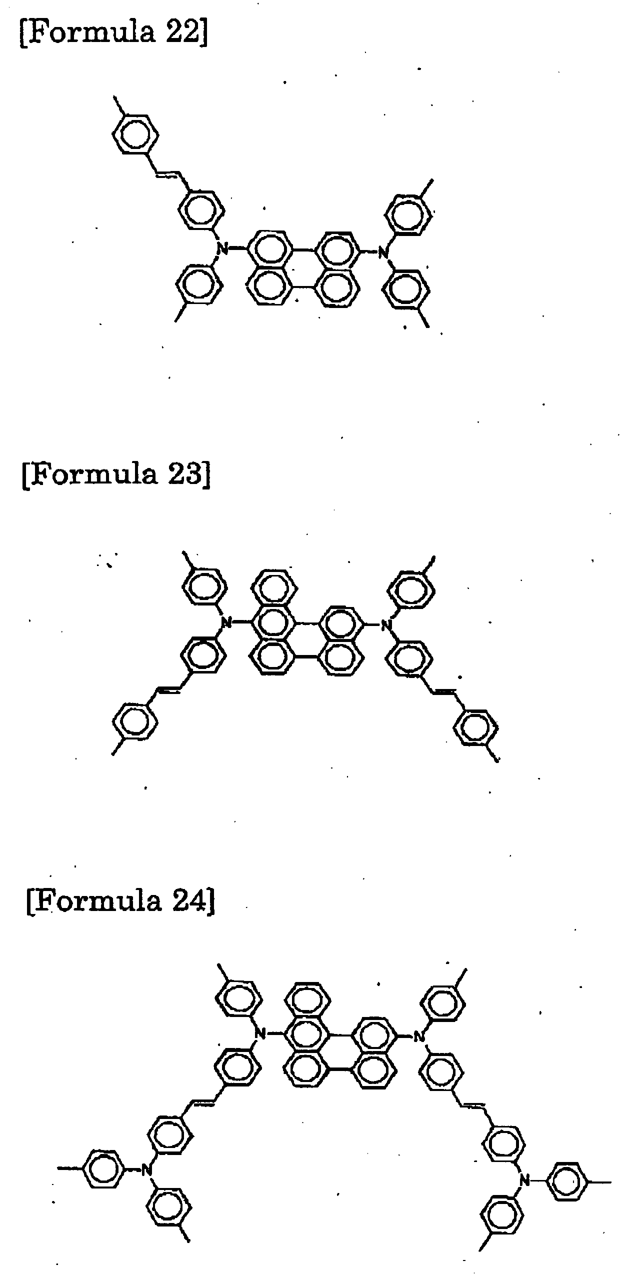

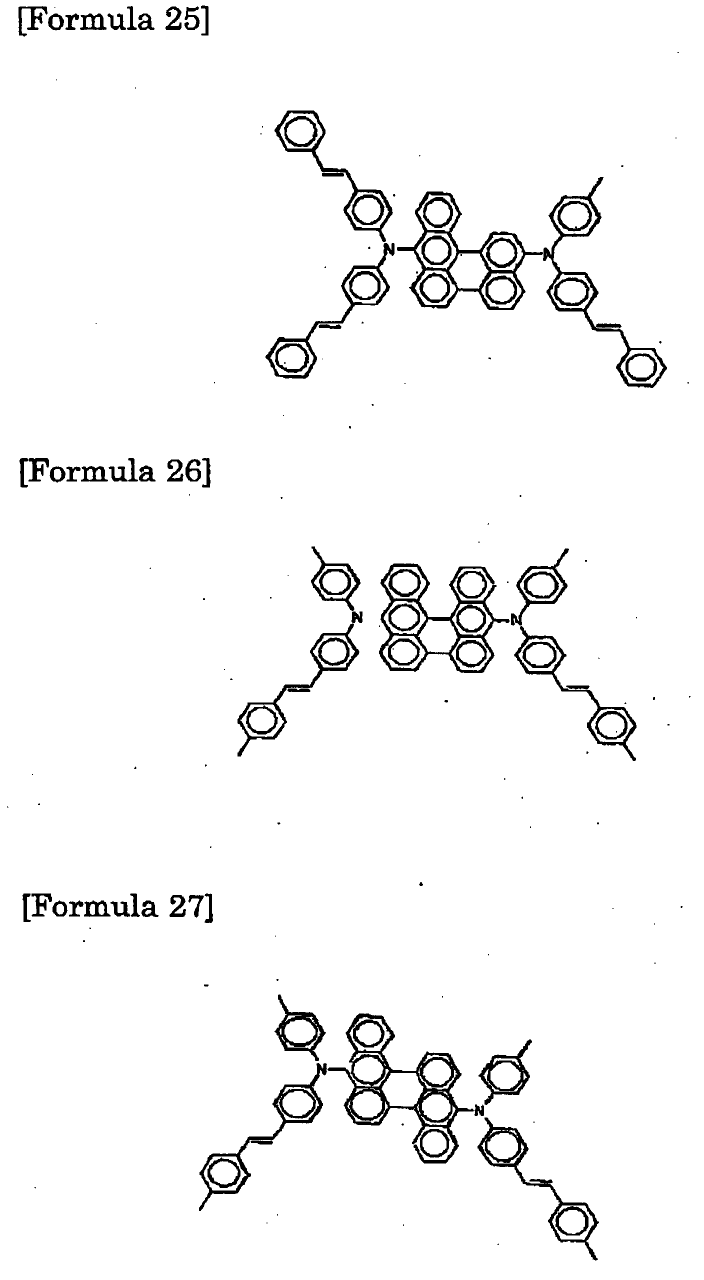

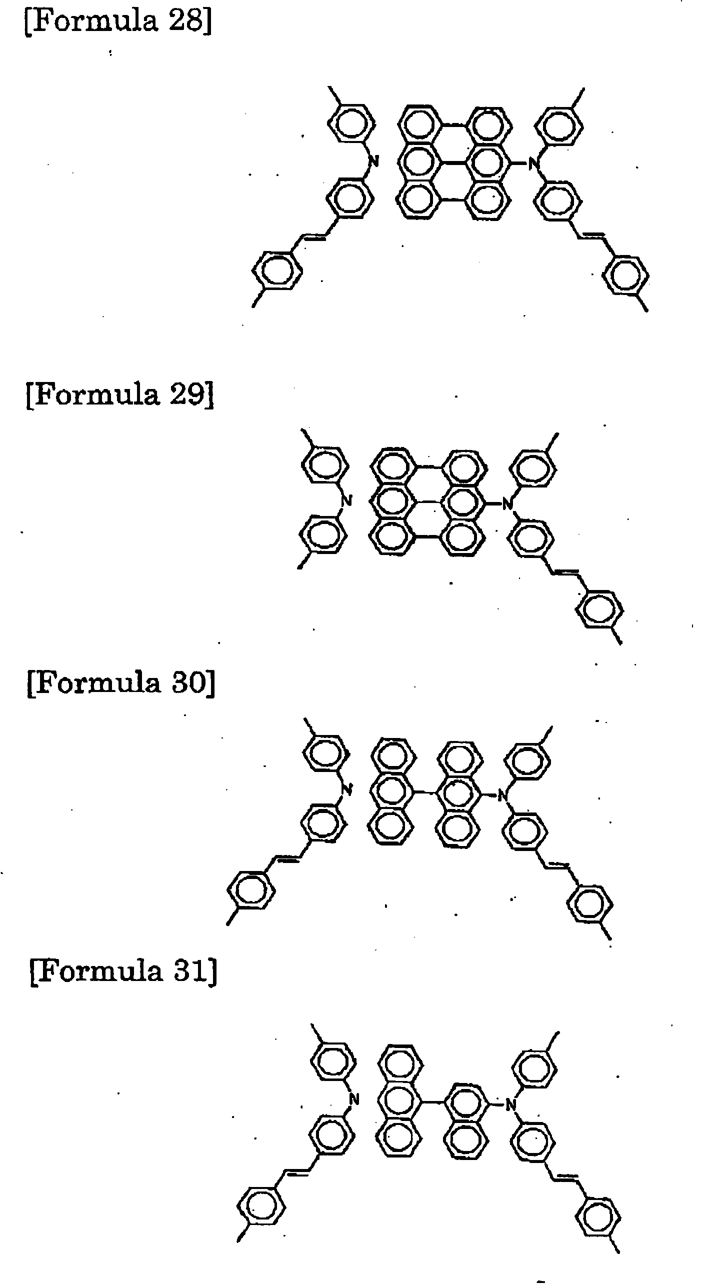

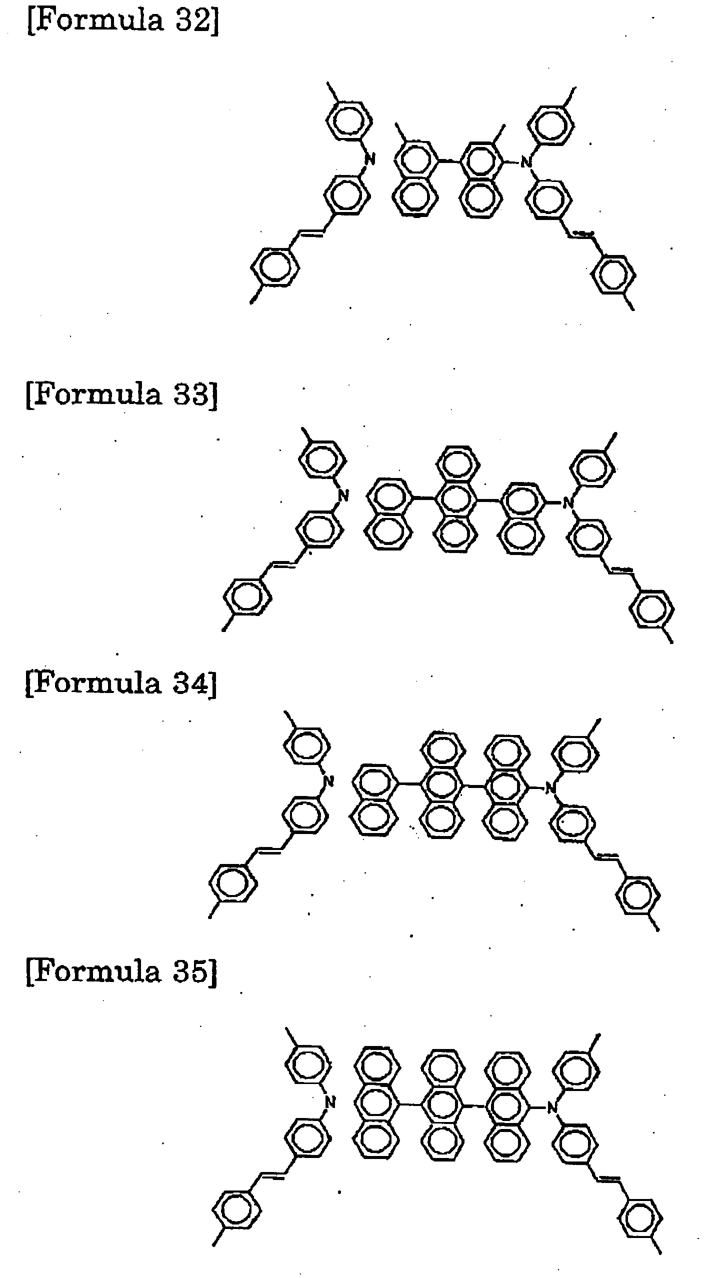

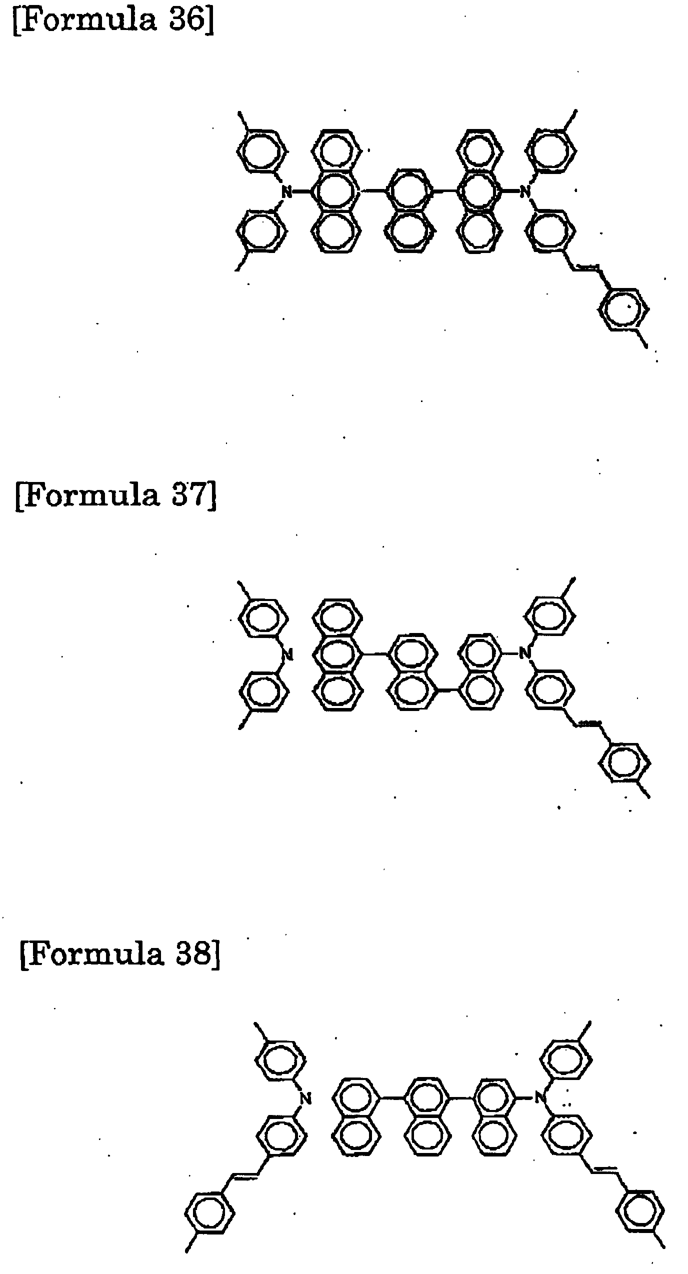

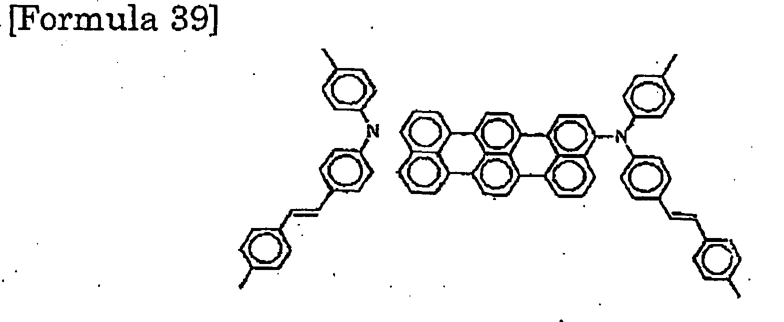

A mixture of the above listed compounds and the other materials having hole-injecting and transporting properties, and/or materials having electron-injecting and transporting properties can be used as light-emitting zone.

The electron-transporting material used in the present invention is not especially restricted and any compounds conventionally used as electron-transporting materials can be used. Examples thereof include oxadiazole derivative such as 2-(4-biphenylyl)-5-(4-t-butylphenyl)-1,3,4-oxadiazole [Formula 40], bis{2-(4-t-butylphenyl)-1,3,4-oxadiazol}-m-phenylene [Formula 41], and triazole derivative ([Formulae 42 and 43] and the like).

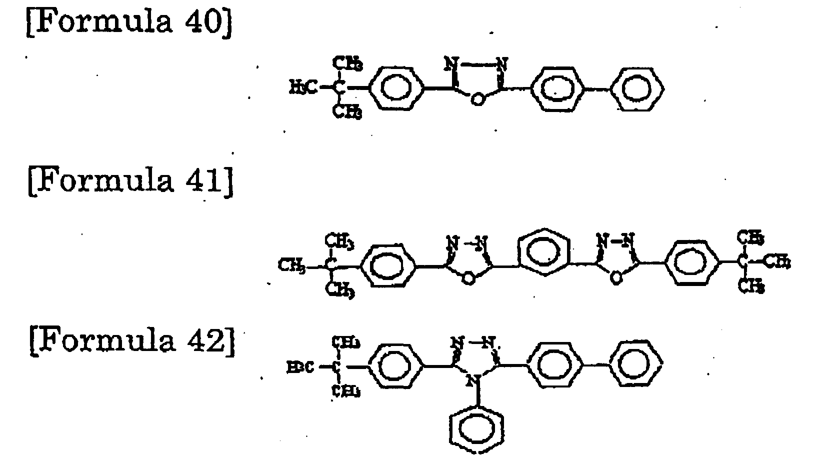

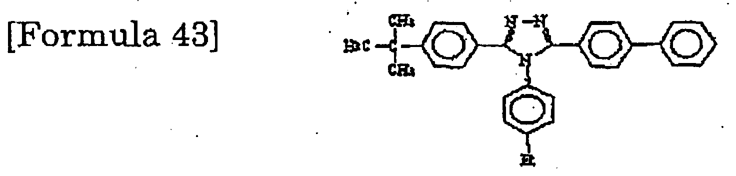

The examples further include quinolinol-based metal complexes shown by Formulae 44, 45 and 46, wherein Q designates a substituted or non-substituted hydroxyl quinoline derivative or a substituted or non-substituted benzoquinoline derivative, "M" designates a metal atom, "n" designates a valency thereof, "L" designates a halogen atom, a substituted or non-substituted alkyl group, a substituted or non-substituted cycloalkyl group, and a substituted or non-substituted aryl group which may includes nitrogen atom.

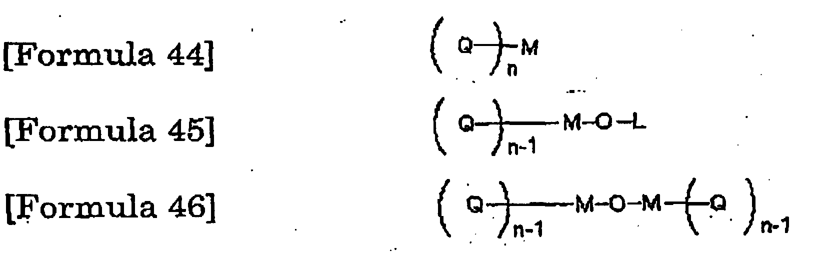

Examples of the compound represented by Formula 44 include the following compounds represented by Formulae 47 to 52.

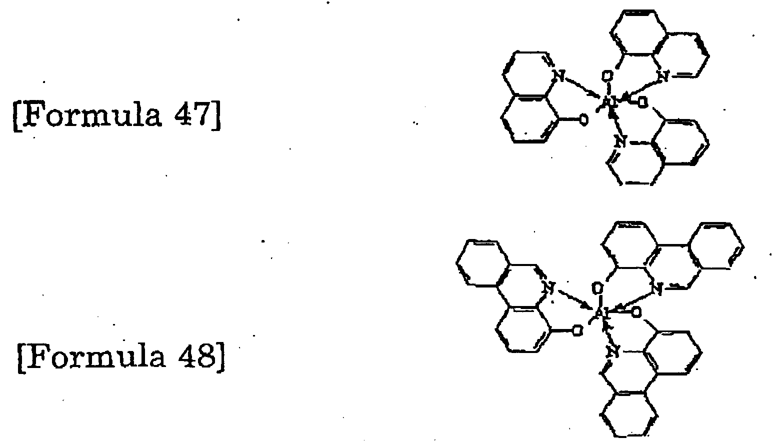

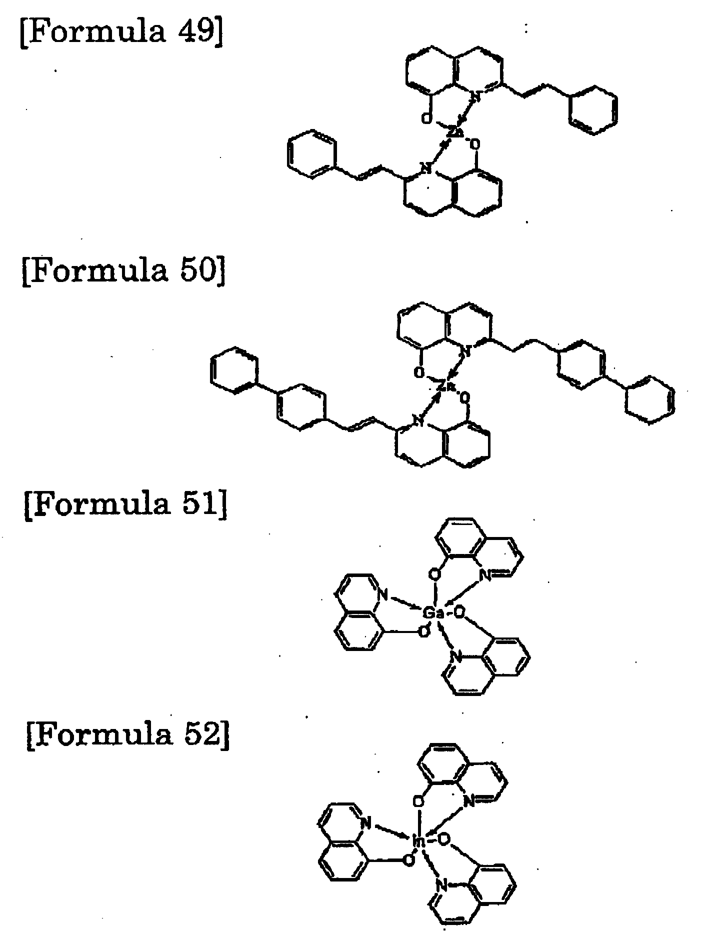

Examples of the compound represented by Formula 45 include following compounds represented by Formulae 53 to 58.

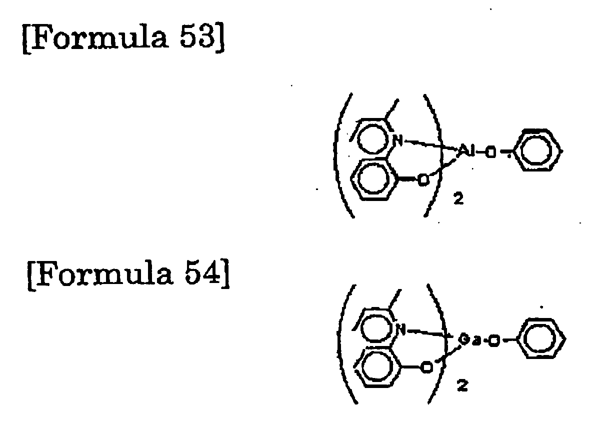

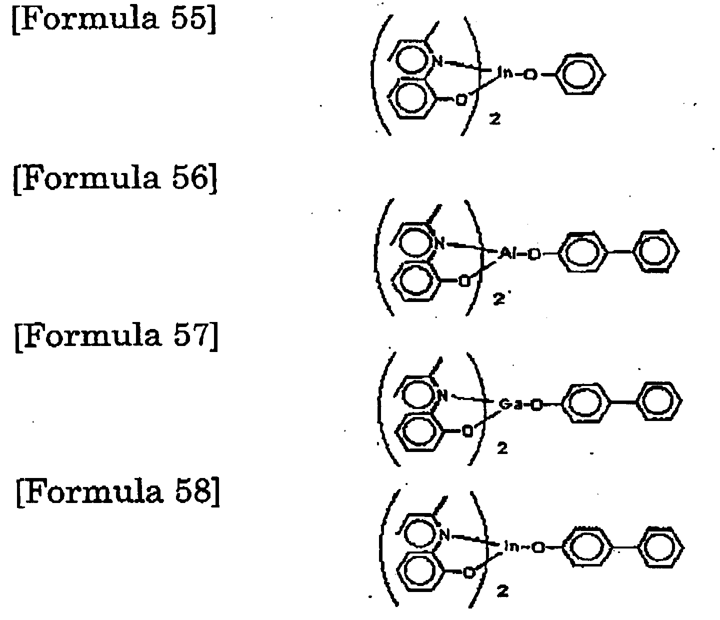

Examples of the compound represented by Formula 46 include following compounds represented by Formulae 59 to 61.

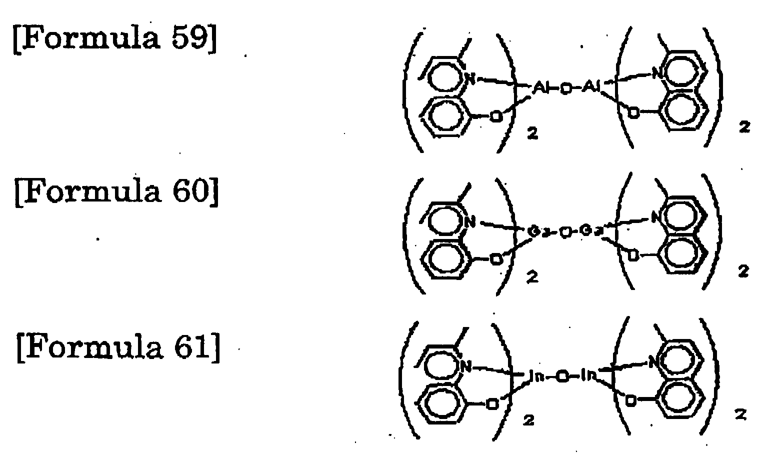

A light-emitting zone which is doped with metal having a smaller work function to make the zone electron-injectable can be used. Although there is no particular limitation imposed on the doping metal, specific examples include lithium, magnesium and aluminum which may constitute the cathode is preferably employed.

Each layer of the organic EL device according to the present invention can be fabricated by any method. Conventionally known methods such as vacuum deposition and spin coating can be employed. The organic thin-film layer which is to be used in the organic EL device of the present invention and contains the compounds of the general formula 1 above can be fabricated by a known method such as vacuum deposition, molecular beam epitaxy (MBE) or coating including dipping, spin coating, casting, bar coating or roll coating of a solution of the compounds dissolved in a proper solvent. Especially, the vacuum evaporation method is preferable.

There is no particular limitation on the thickness of each organic layer of the organic EL device of the present invention. When the thickness of layer is too thin, defects such as spin holes tend to occur. When the thickness of layer is too thick, on the other hand, a high-applied voltage is required, which decreases the efficiency. Usually, the organic layers are therefore preferred to have a thickness within a range of several nm to 1 µm.

Differently from the organic EL device of the first invention, the organic EL device of the second invention essentially includes the hole-injecting zone in addition to the anode, the organic light-emitting zone and the cathode.

The hole-injecting zone includes a layer made of compounds represented by Formula 62, wherein, Ar₁₁ and Ar₁₂ each independently represents a substituted or non-substituted arylene group having 5 to 42 carbon atoms, and Ar₁₃ to Ar_{17,} each independently represents a substituted or non-substituted aryl group having 6 to 20 carbon atoms, and a substituted group includes a halogen atom, a hydroxyl group, a nitro group, a cyano group, a substituted or non-substituted alkyl group, a substituted or non-substituted. alkenyl group, a substituted or non-substituted cycloalkyl group, a substituted or non-substituted alkoxy group, a substituted or non-substituted aromatic hydrocarbon group, a substituted or non-substituted aromatic heterocyclic group, a substituted or non-substituted aralkyl group, a substituted or non-substituted aryloxy group, a substituted or non-substituted alkoxycarbonyl group and a carboxyl group.

The organic light-emitting zone of the second invention includes a layer which contains, either singly or as a mixture, compounds represented by Formula 63, wherein, Ar₁₈ is a substituted or non-substituted arylene group having 5 to 42 carbon atoms, and Ar₁₉ to Ar_{22,} each independently represents a substituted or non-substituted aryl group having 6 to 20 carbon atoms, whereupon substituted groups thereof are a halogen atom, a hydroxyl group, a nitro group, a cyano group, a substituted or non-substituted alkyl group, a substituted or non-substituted alkenyl group, a substituted or non-substituted cycloalkyl group, a substituted or non-substituted alkoxy group, a substituted or non-substituted aromatic hydrocarbon group, a substituted or non-substituted aromatic heterocyclic group, a substituted or non-substituted aralkyl group, a substituted or non-substituted aryloxy group, a substituted or non-substituted alkoxycarbonyl group and a carboxyl group.

Following are examples of compounds used in the layer of the hole-injecting zone of the second invention. But the second invention is not limited to these examples unless the spirit or scope of the invention is changed.

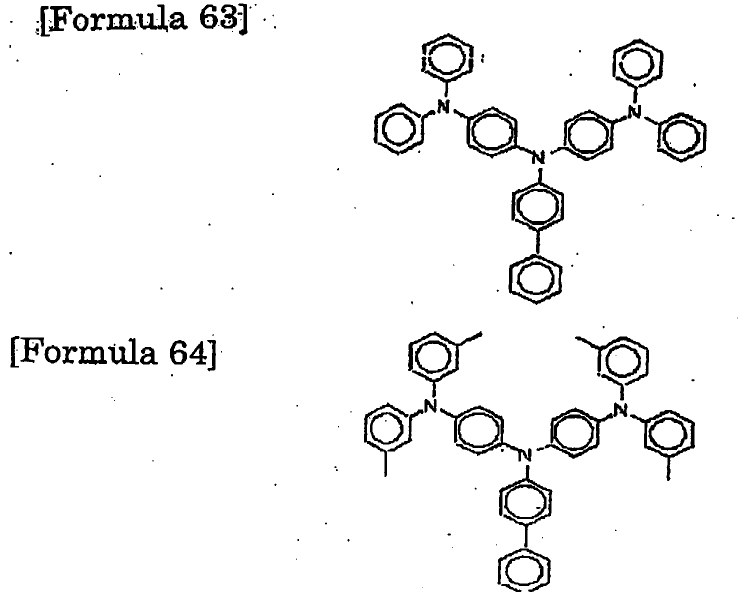

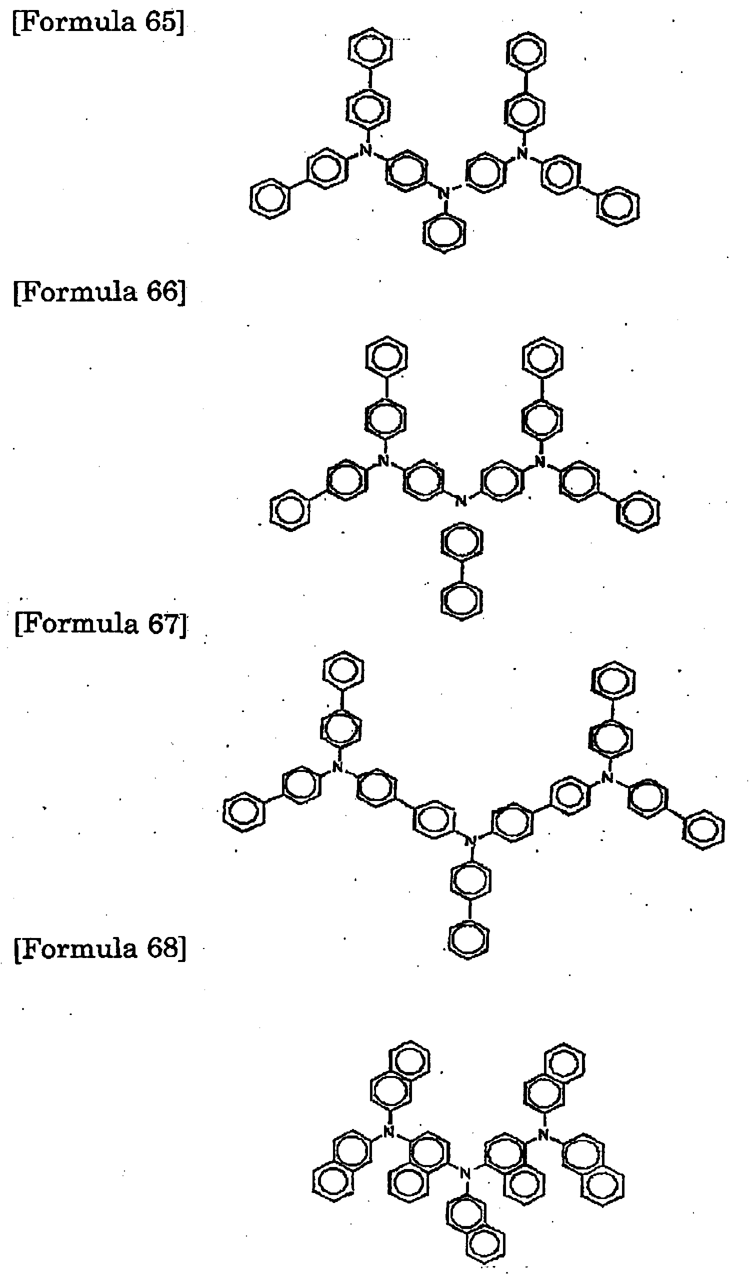

The compounds represented by Formulae 3 to 39 are examples of compounds used as the light-emitting zone of the second invention, however the compounds of the second invention is not limited to these examples unless the sprit or scope of the invention is changed.

The compounds represented by Formulae 40 to 46 are examples of compounds used as the electron-injecting zone of the second invention, however the compounds of the second invention is not r limited to these examples unless the sprit or scope of the invention is changed.

Also in the second invention, a light-emitting zone which is doped with metal having a smaller work function to make the zone electron-injectable can be used. Although there is no particular limitation imposed on the doping metal, specific examples include lithium, magnesium and aluminum which may constitute the cathode is preferably employed.

### Examples

### (Example 1)

A cross-sectional structure of the device used in Example 1 is shown in Fig.1. Hereinafter, the procedures for fabricating the organic thin-layer EL device used in Example 1 are illustrated.

The device is composed of an anode 12/a light-emitting zone 13/a cathode 15. First, ITO was sputtered on a glass substrate to form a film having a sheet resistance of 20 Ω/□ as the anode. The ITO-covered substrate 11 was washed with an alkali cleaning fluid, and then with isopropyl alcohol. The cleaned substrate was irradiated with an ultraviolet light of wavelength 172 nm by Xe₂ lamp for three minutes. Over the anode, a 60 nm thick light-emitting zone was formed by the vacuum deposition of compound represented by Formula 3. Then, a 150 nm thick cathode was formed by the vacuum deposition of magnesium-silver alloy, whereby the organic EL device was fabricated. When a DC voltage of 6V was applied to the device, blue light emission of 200 cd/m² was obtained.

### (Example 2)

In a similar manner to Example 1 except that the light-emitting zone was formed by the spin coating of a solution of Compound represented by Formula 3 in chloroform. When a DC voltage of 6V was applied to the device, blue light emission of 240 cd/m² was obtained.

### (Example 3)

A cross-sectional structure of the device used in Example 3 is shown in Fig.2. Hereinafter, the procedures for fabricating the organic thin-layer EL device used in Example 3 are illustrated.

The device is composed of an anode 12/a light-emitting zone 13/an electron-injecting zone 14/a cathode 15.First, ITO was sputtered on a glass substrate to form a film having a sheet resistance of 20 Ω/□ as the anode. The ITO-covered substrate 11 was washed with an alkali cleaning fluid, and then with isopropyl alcohol. The cleaned substrate was irradiated with an ultraviolet light of wavelength 172 nm by Xe₂ lamp for three minutes. Over the anode, a 60 nm thick light-emitting zone was formed by the vacuum deposition of compound represented by Formula 3. Then, a 25 nm thick electron-injecting zone was formed by the vacuum deposition of compound represented by Formula 53. Then, a 150 nm thick cathode was formed by the vacuum deposition of magnesium-silver alloy, whereby the organic EL device was fabricated. When a DC voltage of 6V was applied to the device, blue light emission of 3600 cd/m² was obtained. The maximum efficiency of the device was 5.3 cd/A.

### (Examples 4 to 8)

In a similar manner to Example 3 except that the compounds used in light-emitting zone and electron-injecting zone were selected as shown in Table 1, an organic EL device was fabricated. The numerals in the light emitting zone and the electron-injecting zone correspond to those of the Formulae.

All the organic EL devices, fabricated in accordance with Examples 1 to 8 exhibited a longer lifetime.

**Table 1**

| Light Emitting Zone | Electron-injecting Zone | Color | Example | Luminance at 6V (cd/m²) | Maximum EffiCiency (cd/A) | Comp. Example | Luminance at 6V (cd/m²) | Maximum EffiCiency (cd/A) |
|---|---|---|---|---|---|---|---|---|
| 4 | 47 | Blue | 4 | 3200 | 4.7 | 6 | 1100 | 3.1 |
| 14 | 47 | Green | 5 | 11000 | 18.2 | 7 | 5100 | 15.1 |
| 17 | 56 | Red | 6 | 3100 | 4.8 | 8 | 2200 | 3.0 |
| 20 | 57 | Reddish orange | 7 | 9500 | 12.2 | 9 | 4600 | 9.8 |
| 30 | 56 | Greenish white | 8 | 5200 | 12.6 | 10 | 2800 | 10.2 |

### (Comparative Example 1)

In a similar manner to Example 1 except that the ITO substrate was not irradiated with ultraviolet light, an organic EL device was fabricated. When a DC voltage of 6V was applied to the device, blue light emission of 90 cd/m² was obtained.

### (Comparative Example 2)

In a similar manner to Example 2 except that the ITO substrate was not irradiated with ultraviolet light, an organic EL device was fabricated. When a DC voltage of 6V was applied to the device, blue light emission of 110 cd/m² was obtained.

### (Comparative Example 3)

In a similar manner to Example 3 except that the ITO substrate was irradiated with ultraviolet light of wavelength 220 nm by KrCl* lamp instead of Xe₂ lamp for three minutes. When a DC voltage of 6V was applied to the device, blue light emission of 300 cd/m² was obtained.

### (Comparative Example 4)

In a similar manner to Example 3 except that the ITO substrate was irradiated with ultraviolet light of wavelength 308 nm by XeCl* lamp instead of Xe₂ lamp for three minutes. When a DC voltage of 6V was applied to the device, blue light emission, of 1700 cd/m² was obtained.

### (Comparative Example 5)

In a similar manner to Example 3 except that the ITO substrate was not irradiated with ultraviolet light, an organic EL device was fabricated. When a DC voltage of 6V was applied to the device, blue light emission of 1000 cd/m² was obtained.

### (Comparative Examples 6 to 10)

In a similar manner to Comparative Example 5 except that the compounds used in light-emitting zone and electron-injecting zone were selected as shown in Table 1, an organic EL device was fabricated.

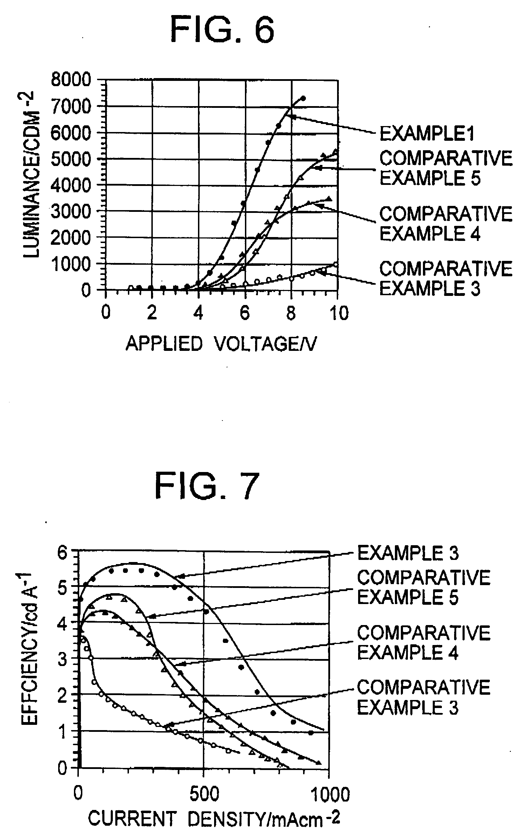

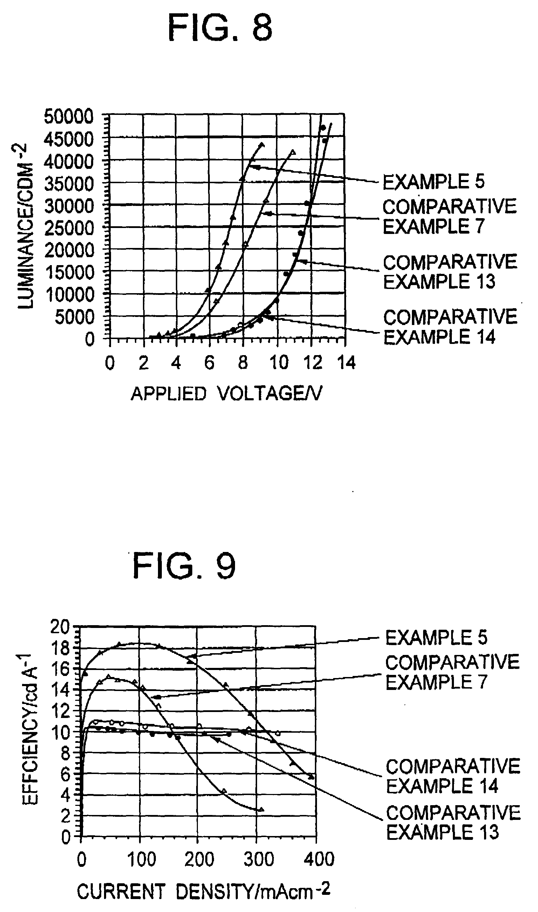

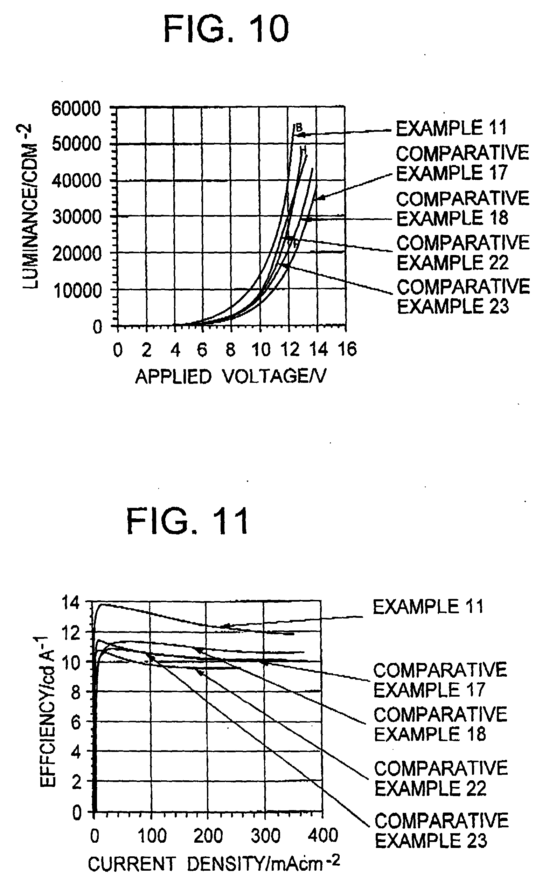

The luminance-applied voltage characteristics are shown in Fig.7 and the current efficiencies-current densities characteristics are shown in Fig.8, when the DC voltages were applied to the respective devices fabricated in Example 3 and Comparative Examples 3 to 5. The luminance-applied voltage characteristics are shown in Fig.9 and the current efficiencies-current densities characteristics are shown in Fig.10, when the DC voltages were applied to the respective devices fabricated in Example 5 and Comparative Examples 7.

As apparent from Figs.7 and 8, the organic EL device having the light-emitting zone in contact with the anode which was irradiated with the ultraviolet light of wavelength 100-200 nm needed lower operating voltage for the same luminance than the device having the anode without the irradiation. That is, the operating voltage at which the luminescence of 100 cd/m² was obtained for the former organic EL device was 3.6 V, and that for the latter was 4.1V.

Further, the maximum luminance was increased from 5400 cd/m² to 7300 cd/m² by the irradiation with ultraviolet light. Moreover, the reduction of the emitting efficiency was suppressed and the maximum efficiency was increased from 4.6 cd/A to 5.3 cd/A by the irradiation with ultraviolet light of wavelength 100-200 nm.

### (Example 9)

A cross-sectional structure of the device used in Example 9 is shown in Fig.3. Hereinafter, the procedures for fabricating the organic thin-layer EL device used in Example 9 are illustrated.

The device is composed of an anode 22/a hole-injecting zone 23/a light-emitting zone 24/a cathode 25. First, ITO was sputtered on a glass substrate to form a film having a sheet resistance of 20 Ω/□ as the anode. The ITO-covered substrate 21 was washed with an alkali cleaning fluid, and then with isopropyl alcohol. The cleaned substrate was irradiated with an ultraviolet light of wavelength 172 nm by Xe₂ lamp for three minutes. Over the anode, a 25 nm thick of hole-injecting zone was formed by the vacuum deposition of compound represented by Formula 63. Then, a 60 nm thick light-emitting zone was formed by the vacuum deposition of compound represented by Formula 3. Then, a 150 nm thick cathode was formed by the vacuum deposition of magnesium-silver alloy, whereby the organic EL device was fabricated. When a DC voltage of 10V was applied to the device, blue light emission of 1100 cd/m² was obtained.

### (Example 10)

A cross-sectional structure of the device used in Example 10 is shown in Fig.4. Hereinafter, the procedures for fabricating the organic thin-layer EL device used in Example 10 are illustrated.

The device is composed of an anode 22/a hole-injecting zone 23/a light-emitting zone 24/an electron-injecting zone 26/a cathode 25. First, ITO was sputtered on a glass substrate to form a film having a sheet resistance of 20 Ω/□ as the anode. The ITO-covered substrate 21 was washed with an alkali cleaning fluid, and then with isopropyl alcohol. The cleaned substrate was irradiated with an ultraviolet light of wavelength 172 nm by Xe₂ lamp for three minutes. Over the anode, a 25 nm thick of hole-injecting zone was formed by the vacuum deposition of compound represented by Formula 64. Then, a 60 nm thick light-emitting zone was formed by the vacuum deposition of compound represented by Formula 14. Then, a 25 nm thick electron-injecting zone was formed by the vacuum deposition of compound represented by Formula 53. Then, a 150 nm thick cathode was formed by the vacuum deposition of magnesium-silver alloy, whereby the organic EL device was fabricated. When a DC voltage of 10V was applied to the device, green light emission of 6800 cd/m² was obtained. The maximum efficiency of the device was 14.3 cd/A.

### (Example 11)

A cross-sectional structure of the device used in Example 11 is shown in Fig.5. Hereinafter, the procedures for fabricating the organic thin-layer EL device used in Example 11 are illustrated.

The device is composed of an anode 22/a hole-injecting zone 23 having a hole injection layer 27 and a hole transport layer 28/a light-emitting zone 24/an electron-injecting zone 26/a cathode 25. First, ITO was sputtered on a glass substrate to form a film having a sheet resistance of 20 Ω/□ as the anode. The ITO-covered substrate 21 was washed with an alkali cleaning fluid, and then with isopropyl alcohol. The cleaned substrate was irradiated with an ultraviolet light of wavelength 172 nm by Xe₂ lamp for three minutes. Over the anode, a 25 nm thick of hole injection layer of the hole-injecting zone was formed by the vacuum deposition of compound represented by Formula 65. Then, a 20 nm thick of hole transport layer of the hole-injecting zone was formed by the vacuum deposition of N,N'-diphenyl-N,N'-bis(1-naphthyl)-1,1'-biphenyl-4,4'-diamine. Then, a 60 nm thick light-emitting zone was formed by the vacuum deposition of compound represented by Formula 14. Then, a 25 nm thick electron-injecting zone was formed by the vacuum deposition of compound represented by Formula 53. Then, a 150 nm thick cathode was formed by the vacuum deposition of magnesium-silver alloy, whereby the organic EL device was fabricated. When a DC voltage of 10V was applied to the device, green light emission of 8800 cd/m² was obtained. The maximum efficiency of the device was 16.5 cd/A.

### (Example 12)

In a similar manner to Example 10 except for the use of the compounds represented by Formula 63 as hole-injecting zone, Formula 17 as light-emitting zone and Formula 56 as electron-injecting zone, an organic EL device was fabricated. When a DC voltage of 10V was applied to the device, red light emission of 1800 cd/m² was obtained. The maximum efficiency of the device was 4.5 cd/A.

### (Example 13)

In a similar manner to Example 11 except for the use of the compounds represented by Formula 64 as hole injection layer, Formula 20 as light-emitting zone and Formula 47 as electron-injecting zone, an organic EL device was fabricated. When a DC voltage of 10V was applied to the device, reddish orange light emission of 8500 cd/m² was obtained. The maximum efficiency of the device was 12.6 cd/A.

### (Example 14)

In a similar manner to Example 11 except for the use of the compounds represented by Formula 66 as hole injection layer, Formula 30 as light-emitting zone and Formula 53 as electron-injecting zone, an organic EL device was fabricated. When a DC voltage of 10V was applied to the device, greenish white light emission of 7600 cd/m² was obtained. The maximum efficiency of the device was 13.1 cd/A.

All the organic EL devices fabricated in accordance with Examples 9 to 14 exhibited a longer lifetime.

### (Comparative Example 11)

In a similar manner to Example 9 except that the ITO substrate was not irradiated with ultraviolet light, an organic EL device was fabricated. When a DC voltage of 10V was applied to the device, blue light emission of 870 cd/m² was obtained.

### (Comparative Example 12)

In a similar manner to Example 10 except that the ITO substrate was not irradiated with ultraviolet light, an organic EL device was fabricated. When a DC voltage of 10V was applied to the device, green light emission of 4900 cd/m² was obtained. The maximum efficiency of the device was 11.2 cd/A.

### (Comparative Example 13)

In a similar manner to Example 11 except that the ITO substrate was irradiated with ultraviolet light of wavelength 220 nm by KrCl* lamp instead of Xe₂ lamp for three minutes. When a DC voltage of 10V was applied to the device, green light emission of 5000 cd/m² was obtained. The maximum efficiency of the device was 11.1 cd/A.

### (Comparative Example 14)

In a similar manner to Example 11 except that the ITO substrate was not irradiated with ultraviolet light, an organic EL device was fabricated. When a DC voltage of 10V was applied to the device, green light emission of 6600 cd/m² was obtained. The maximum efficiency of the device was 11.2 cd/A.

### (Comparative Example 15)

In a similar manner to Example 12 except that the ITO substrate was not irradiated with ultraviolet light, an organic EL device was fabricated. When a DC voltage of 10V was applied to the device, red light emission of 1100 cd/m² was obtained. The maximum efficiency of the device was 2.7 cd/A.

### (Comparative Example 16)

In a similar manner to Example 13 except that the ITO substrate was not irradiated with ultraviolet light, an organic EL device was fabricated. When a DC voltage of 10V was applied to the device, reddish orange light emission of 5300 cd/m² was obtained. The maximum efficiency of the device was 10.2 cd/A.

### (Comparative Example 17)

In a similar manner to Example 14 except that the ITO substrate was not irradiated with ultraviolet light, an organic EL device was fabricated. When a DC voltage of 10V was applied to the device, greenish white light emission of 4800 cd/m² was obtained. The maximum efficiency of the device was 10.8 cd/A.

### (Comparative Example 18)

In a similar manner to Example 10 except for the use of a triphenylamine derivative represented by Formula 69 as hole-injecting zone, the compounds represented by Formula 14 as light-emitting zone and Formula 53 as electron-injecting zone, an organic EL device was fabricated. When a DC voltage of 10V was applied to the device, green light emission of 18000 cd/m² was obtained. The maximum efficiency of the device was 8.9 cd/A.

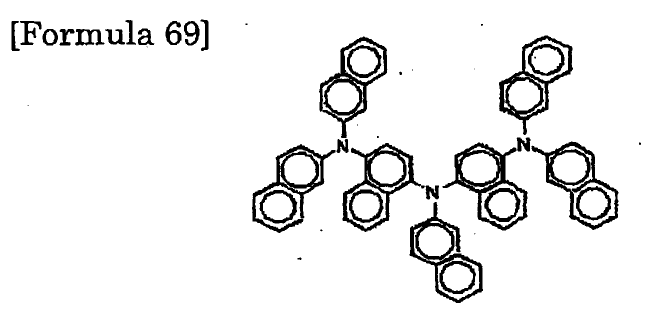

### (Comparative Example 19)

In a similar manner to of Comparative Example 18 except that the ITO substrate was not irradiated with ultraviolet light, an organic EL device was fabricated. When a DC voltage of 10V was applied to the device, green light emission of 16000 cd/m² was obtained. The maximum efficiency of the device was 9.2 cd/A.

### (Comparative Example 20)

In a similar manner to Example 11 except for the use of the compounds represented by Formula 69 as hole injection layer and Formula 47 as electron-injecting zone, an organic. EL device was fabricated. When a DC voltage of 10V was applied to the device, green light emission of 8300 cd/m² was obtained.

### (Comparative Example 21)

In a similar manner to of Comparative Example 20 except that the ITO substrate was not irradiated with ultraviolet light, an organic EL device was fabricated. When a DC voltage of 10V was applied to the device, green light emission of 9700 cd/m² was obtained.

The luminance-voltage characteristics are shown in Fig.10 and the current efficiencies-current densities characteristics are shown in Fig.11, when the DC voltages were applied to the respective devices fabricated in Example 11 and Comparative Examples 17, 18, 22 and 23.

As apparent from Figs.10 and 11, the organic EL device having the compound represented by Formula 62 in the hole-injecting zone and the anode which was irradiated with the ultraviolet light of wavelength 100-200 nm had a lower voltage at which substantially the same luminance was obtained than the other organic EL device having the anode without the ultraviolet ray irradiation treatment. That is, the voltage at which the luminescence of 100 cd/m² was obtained for the former organic EL device was 4.2 V, and that for the latter was 5.4 V. The ultraviolet ray irradiation treatment reduced the voltage at which substantially the same luminance was obtained.

Further, the maximum luminance was increased from 42000 cd/m² to 53000 cd/m² by the irradiation with ultraviolet light. Moreover, the reduction of the emitting efficiency was suppressed and the maximum efficiency was increased from 11.2 cd/A to 13.4 cd/A by the irradiation of the ultraviolet light of wavelength 100-200 nm. However, in the organic EL device having the compound represented by Formula 69 as the hole-injecting zone, the performance of the organic EL device was not improved even if the anode was irradiated with the ultraviolet light of wavelength 100-200 nm.

Since the above embodiments are described only for examples, the present invention is not limited to the above embodiments and various modifications or alternations can be easily made therefrom by those skilled in the art without departing from the scope of the present invention.

## Claims

1. An organic EL device comprising:
at least an anode (12), a cathode (15) and an organic light-emitting zone which consists one or more than one organic thin-film layers and is disposed therebetween and adjacent to the anode (12) characterized in that: the anode (12) is irradiated with ultraviolet light of wavelength 100-200 nm.

2. The organic EL device as defined in claim 1, wherein the layer in contact with the anode contains, either singly or as a mixture, a compound represented by Formula 1, 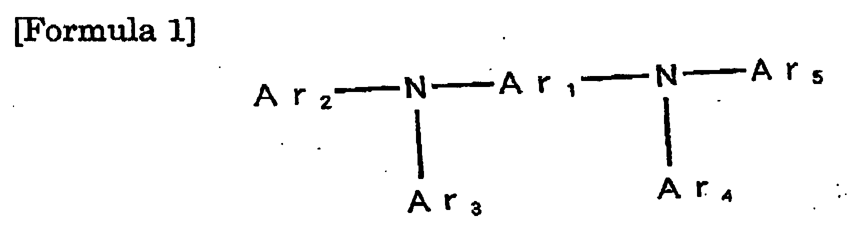 wherein Ar₁ designates a substituted or non-substituted arylene group having 5 to 42 carbon atoms, Ar₂ to Ar₅ designate, independently with one another, a substituted or non-substituted aryl group having 6 to 20 carbon atoms, and at least one of Ar₂ to Ar₅ has a substituted or non-substituted styryl group, and the substituted group includes a halogen atom, a hydroxyl group, a nitro group, a cyano group, a substituted or non-substituted alkyl group, a substituted or non-substituted alkenyl group, a substituted or non-substituted cycloalkyl group, a substituted or non-substituted alkoxy group, a substituted or non-substituted aromatic hydrocarbon group, a substituted or non-substituted aromatic heterocyclic group, a substituted or non-substituted aralkyl group, a substituted or non-substituted aryloxy group, a substituted or non-substituted alkoxycarbonyl group and a carboxyl group.

3. The organic EL device as defined in claim 1, wherein an electron-injecting zone is present between the organic light-emitting zone and the cathode(15).

4. The organic EL device as defined in claim 2, wherein an electron-injecting zone is present between the organic light-emitting zone and the cathode(15).

5. The organic EL device as defined in claim 1, wherein the anode(12) is an electroconductive oxide having a work function not less than 4 eV.

6. The organic EL device as defined in claim 2, wherein the anode(12) is an electroconductive oxide having a work function not less than 4 eV.

7. The organic EL device as defined in claim 3, wherein the anode(12) is an electroconductive oxide having a work function not less than 4 eV.

8. The organic EL device as defined in claim 4, wherein the anode(12) is an electroconductive oxide having a work function not less than 4 eV.

9. A method for fabricating an organic EL device comprising the steps of:
irradiating an anode(12) with ultraviolet light of wavelength 100-200 nm;
forming an organic layer including a light-emitting zone adjacent to the anode(12); and
forming a cathode(15) on the organic layer.

10. The method as defined in claim 9 further comprising the step of forming an electron-injecting zone(14).

11. An organic EL device comprising:
at least an anode(22) being irradiated with ultraviolet light of wavelength 100-200 nm, a hole-injecting zone, a light-emitting zone and a cathode(25), the hole-injecting zone and the organic light-emitting zone being sandwiched between the anode(22) and the cathode(25), and a hole-injecting zone containing, either singly or as a mixture, a compound represented by Formula 62: 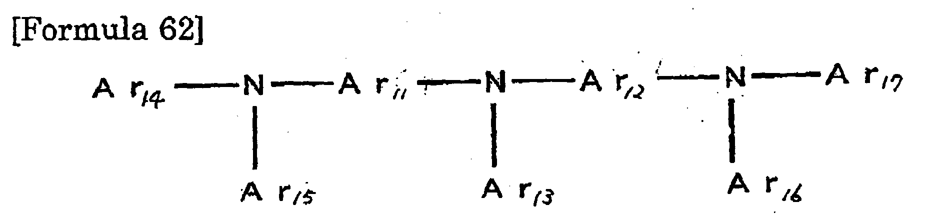 wherein, Ar₁₁ and Ar₁₂ each independently represents a substituted or non-substituted arylene group having 5 to 42 carbon atoms, and Ar₁₃o Ar₁₇ each independently represents a substituted or non-substituted aryl group having 6 to 20 carbon atoms, and a substituted group includes a halogen atom, a hydroxyl group, a nitro group, a cyano group, a substituted or non-substituted alkyl group, a substituted or non-substituted alkenyl group, a substituted or non-substituted cycloalkyl group, a substituted or non-substituted alkoxy group, a substituted or non-substituted aromatic hydrocarbon group, a substituted or non-substituted aromatic heterocyclic group, a substituted or non-substituted aralkyl group, a substituted or non-substituted aryloxy group, a substituted or non-substituted alkoxycarbonyl group and a carboxyl group.

12. The organic EL device as defined in claim 11, wherein the organic light-emitting zone includes, either singly or as a mixture, a compound represented by Formula 1.

13. The organic EL device as defined in claim 11, wherein an electron-injecting zone (26) is present between the organic light-emitting zone and the cathode (25).

14. The organic EL device as defined in claim 12, wherein an electron-injecting zone (26) is present between the organic light-emitting zone and the cathode (25).

15. The organic EL device as defined in claim 11, wherein the anode(22) is an electroconductive oxide having a work function not less than 4 eV.

16. The organic EL device as defined in claim 12, wherein the anode (22) is an electroconductive oxide having a work function not less than 4 eV.

17. The organic EL device as defined in claim 13, wherein the anode(22) is an electroconductive oxide having a work function not less than 4 eV.

18. The organic EL device as defined in claim 14, wherein the anode (22) is an electroconductive oxide having a work function not less than 4 eV.

19. A method for fabricating an organic EL device comprising the steps of:
irradiating an anode (22) with ultraviolet light of wavelength 100-200 nm;
forming a hole-injecting zone (23) on the anode(22);
forming a light-emitting zone; and
forming a cathode(25) on the organic layer.

20. The method as defined in claim 19 further comprising the step of forming an electron-injecting zone(26).
